(19) **Europäisches Patentamt**
**European Patent Office**
**Office européen des brevets**

(11) **EP 4 462 147 A1**

(12) **EUROPEAN PATENT APPLICATION**

(43) Date of publication:
**13.11.2024 Bulletin 2024/46**

(21) Application number: **23172477.4**

(22) Date of filing: **10.05.2023**

(51) International Patent Classification (IPC):
**G01R 33/56** $^{(2006.01)}$ **G01R 33/48** $^{(2006.01)}$
**G01R 33/565** $^{(2006.01)}$

(52) Cooperative Patent Classification (CPC):
**G01R 33/5605;** G01R 33/4828; G01R 33/56545

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
• **KEUPP, Jochen**
**5656AG Eindhoven (NL)**
• **EGGERS, Holger**
**5656AG Eindhoven (NL)**

(74) Representative: **Philips Intellectual Property & Standards**
**High Tech Campus 52**
**5656 AG Eindhoven (NL)**

(54) **MR IMAGING USING CEST CONTRAST ENHANCEMENT**

(57) The invention relates to a method of MR imaging of at least a portion of a body (10) placed in a main magnetic field $B_0$ within the examination volume of an MR system. It is an object of the invention to provide a CEST MR imaging method enabling a precise fat correction, preferably based on a small number of saturation frequency offset acquisitions. The method of the invention comprises the following steps: a) acquiring MR signals by subjecting the portion of the body (10) to a CEST imaging protocol including RF saturation at a number of different saturation frequency offsets; b) reconstructing a Z-spectrum from the acquired MR signals for each voxel of an MR image; c) modelling a Z-spectrum background including contributions from direct water saturation, magnetization transfer, and fat signal, wherein parameters of the model are determined by fitting the modelled Z-spectrum background to the reconstructed Z-spectrum for each voxel, omitting a region of the Z-spectrum affected by the CEST effect; and d) deriving a CEST contrast image by computing the difference between the modelled Z-spectrum background and the reconstructed Z-spectrum for each voxel. Moreover, the invention relates to an MR system (1) for carrying out the method of the invention and to a computer program to be run on an MR system.

Fig. 3

EP 4 462 147 A1

**Description**

FIELD OF THE INVENTION

The invention relates to the field of magnetic resonance (MR) imaging. It concerns a method of MR imaging of at least a portion of a body placed in a main magnetic field Bo within the examination volume of an MR system. The invention also relates to an MR system and to a computer program for an MR system.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

In some medical applications, the difference in MR signal intensity from standard MR protocols, i.e. the contrast between different tissues, might not be sufficient to obtain satisfactory clinical information. In this case, contrast enhancing techniques are applied. A known approach for contrast enhancement and increase of MR detection sensitivity (by orders of magnitude) is the known method based on "Chemical Exchange Saturation Transfer" (CEST), as initially described by Balaban et al. (see e.g. US 6,962,769 B1). With this CEST technique, the image contrast is obtained by altering the intensity of the water proton signal in the presence of a contrast agent or an endogenous molecule with a proton pool resonating at a different frequency than the main water resonance. This is achieved by selectively saturating the nuclear magnetization of the pool of exchangeable protons which resonate at a frequency different from the water proton resonance. Exchangeable protons can be provided by exogenous CEST contrast agents (e.g. DIACEST, PARACEST or LIPOCEST agents), but can also be found in biological tissue (i.e., endogenous amide protons in proteins and peptides, protons in glucose or protons in metabolites like choline or creatinine). A frequency-selective saturation RF pulse that is matched to the MR frequency of the exchangeable protons is used for this purpose. The saturation of the MR signal of the exchangeable protons is subsequently transferred to the MR signal of nearby water protons within the body of the examined patient by chemical exchange with the water protons, thereby decreasing the water proton MR signal. The selective saturation at the MR frequency of the exchangeable protons thus gives rise to a negative contrast in a proton-density weighted MR image.

Amide proton transfer (APT) MR imaging, which is a CEST technique based on endogenous exchangeable protons, allows highly sensitive and specific detection of pathological processes on a molecular level, like increased protein concentrations in malignant tumor tissue. The APT signal is also sensitively reporting on locally altered pH levels - because the exchange rate is pH dependent - which can e.g. be used to characterize ischemic stroke. APT/CEST MR imaging has several advantages over conventional MR contrasts with or without contrast agents. APT/CEST MR imaging allows highly specific detection and differentiation of exogenous and endogenous contrasts, which is much more sensitive then e.g. spectroscopic MR/NMR techniques. This high sensitivity (SNR efficiency) can be used to obtain molecular contrast information at a resolution comparable to typical MR imaging applications in clinically acceptable examination times.

Compared with MR signals acquired without RF saturation, the signal reductions at certain saturation frequency offsets derive not only from the CEST effect, but also from direct saturation of the water protons and, moreover, from magnetization transfer from semisolid macromolecules during in vivo imaging. Direct saturation and also magnetization transfer can be considered to cause signal reductions that are symmetrical with respect to the resonance frequency of water protons. In conventional CEST MR imaging, therefore, the effect of the saturation transfer of exchangeable protons to water is conventionally identified for each image voxel by an asymmetry analysis of the amplitude of the acquired MR signals as a function of the saturation frequency offset (so-called Z-spectrum). This asymmetry analysis is performed with respect to the MR frequency of water protons, which, for convenience, is assigned to a saturation frequency offset of 0 ppm.

The measurement of the amplitude of the acquired MR signals as a function of the saturation frequency offset and the asymmetry analysis are inherently very sensitive to any inhomogeneity of the main magnetic field Bo. This is because a small shift of the center frequency (e.g. a saturation frequency offset of 0.1 ppm relative to the chemical shift of water) easily causes a variation of more than 10% in the asymmetry data. This variation results in large artifacts in the finally reconstructed CEST contrast images. It has been shown (Zhou et al., Magnetic Resonance in Medicine, 60, 842-849, 2008) that the Bo inhomogeneity can be corrected in APT imaging on a voxel-by-voxel basis through recentering of the Z-spectrum on the basis of a separately acquired Bo map.

Another issue in CEST MR imaging is that a robust elimination of signal contributions from fat protons is often difficult, in particular in the presence of Bo inhomogeneity. However, residual fat signal contributions result in a strongly biased asymmetry of the amplitude of the acquired MR signals as a function of the saturation frequency offset near the chemical shift of fat protons at -3.4 ppm relative to the MR frequency of water protons. This is of particular concern in applications in which MR images of organs with significant fat content are to be acquired, such as the liver or the breast. CEST imaging protocols employing fat suppression pulses have successfully been used to reduce artifacts caused by nearby fatty tissues.

However, fat suppression (alone), e.g. using SPIR/STIR/SPAIR RF pulses, is typically insufficient to correct partial volume fat effects in CEST MR imaging. Only a few percent residual fat signal (which spatially varies with the inhomogeneity of the RF field) may be qualitatively acceptable for removing fat from MR images in general, but it still causes severe artifacts in CEST MR imaging.

Furthermore, standard fat suppression pulses tend to fail in combination with RF saturation for CEST Z-spectral acquisitions in the frequency range of the fat protons. In fact, combined RF saturation and fat suppression (e.g., a selective inversion pulse in SPIR) may even increase signal intensity near the fat frequencies. The reason is that with the fat signal saturated near, e.g., -3.4 ppm, the inversion RF pulse has no effect, and the fat signal quickly reappears via saturation recovery. As a result, the "fat side" of the Z-spectrum gets raised and thus creates false positive asymmetry.

CEST-Dixon techniques have been proposed to precisely correct for fat contribution by basing the CEST analysis on the water only images. However, robustness is often compromised, because of the interaction between RF saturation and Dixon water/fat separation. A fixed multi-line fat spectrum is used for the calculation of water and fat fractions from multi-echo MR signals, but it turns out that the CEST RF saturation selectively removes some of the fat spectral lines which may cause errors in the water-fat separation (or even water/fat swaps) for various frequency offsets in the Z-spectrum.

## SUMMARY OF THE INVENTION

From the foregoing it is readily appreciated that there is a need for an improved MR imaging technique. It is consequently an object of the invention to provide a CEST MR imaging method and an MR system enabling a precise fat correction, preferably based on a small number of saturation frequency offset acquisitions. This would enable the clinical use of 2D and 3D protocols for body applications of CEST MR imaging.

In accordance with the invention, a method of MR imaging of at least a portion of a body placed in a main magnetic field Bo within the examination volume of an MR system is disclosed. The method of the invention comprises the following steps:

a) acquiring MR signals by subjecting the portion of the body to a CEST imaging protocol including RF saturation at a number of different saturation frequency offsets;
b) reconstructing a Z-spectrum from the acquired MR signals for each voxel of an MR image;
c) modelling a Z-spectrum background including contributions from direct water saturation, magnetization transfer, and fat signal, wherein parameters of the model are determined by fitting the modelled Z-spectrum background to the reconstructed Z-spectrum for each voxel, omitting a region of the Z-spectrum affected by the CEST effect; and
d) deriving a CEST contrast image by computing the difference between the modelled Z-spectrum background and the reconstructed Z-spectrum for each voxel.

In accordance with the invention, the portion of the body is subjected to saturation RF pulses each having a saturation frequency offset relative to the MR frequency of water protons. Corresponding to conventional CEST MR imaging, saturation RF pulses are irradiated at different saturation frequency offsets (e.g. between +/- 3.5 ppm) around the MR frequency of water protons (0 ppm). After each saturation step, MR signals are acquired, e.g. by means of a spin echo-type sequence. The steps of RF saturation and MR signal acquisition are repeated for different saturation frequency offsets. Z-spectra are reconstructed in the conventional fashion from the acquired MR signals for each voxel of a given MR image slice or volume (2D or 3D).

The invention proposes that the background of the Z-spectrum of the CEST acquisition is modelled for each voxel on the basis of contributions from direct water saturation, magnetization transfer, and fat signal. This approach yields an accurate and reliable fit of the Z-spectrum data reconstructed from the acquired MR signals to the model of the Z-spectrum background signal. In more detail, the modelled Z-spectrum background is fitted to the reconstructed Z-spectrum for each voxel according to the invention, wherein specifically the region of the Z-spectrum affected by the CEST effect (where the asymmetry of the Z-spectrum caused by the CEST effect is expected) is omitted. Then the residual between the model fit and the measured data provides an accurate result for the contribution of the CEST effect. This means that the desired CEST contrast image is finally obtained by computing the difference between the modelled Z-spectrum background (fitted to the reconstructed Z-spectrum) and the reconstructed Z-spectrum for each voxel, this time specifically in the region of the Z-spectrum affected by the CEST effect, i.e. the region during the fitting procedure. The CEST contrast image can thus be regarded as the residual of the fit of the Z spectrum background for each voxel.

The invention widens the application field of CEST to breast and abdomen examinations in which partial volume effects are significant, mainly because fat saturation effects are accurately corrected for.

In an embodiment of the invention, the CEST imaging protocol further includes fat suppression. It is an observation of the invention that the fat suppression leads to a simplification of the shape of the Z-spectrum and to a modified (inverted) residual contribution of the fat signal. The influence of partial volume fat content on the Z-spectrum is reduced and variations depending on the echo time of the used imaging sequence, e.g. in-phase vs. out-of-phase contributions from fat protons to the acquired MR signals, are small. Remaining fat contributions resulting from interactions of fat suppression and RF saturation are corrected for by modelling the Z-spectrum background including not only contributions from direct water saturation, magnetization transfer (from semisolid macromolecules) but also from fat signals, modelled, e.g., by an (inverted) multi-line fat spectrum.

In another embodiment, the method of the invention further comprises the steps of obtaining a Bo map and applying a saturation frequency offset correction to the reconstructed Z-spectra according to the Bo map. The Bo map within the imaged portion of the body can be determined from the acquired MR signals by means of a single-point or multi-point Dixon technique. In general, a Bo field map, a water image and a fat image are obtained by means of a Dixon technique. This embodiment thus permits the application of Dixon methods for both Bo mapping as well as water/fat separation simultaneously. Alternatively, the Bo map can be determined separately by any Bo mapping technique known as such in the art. It is also possible to determine the Bo shift for each voxel from the reconstructed Z-spectrum itself (as the frequency offset at the global minimum of the Z-spectrum).

In a possible embodiment, the contribution from direct saturation of water proton spins is reproduced in the model of the Z-spectrum background by a Lorentzian curve of amplitude $A_L$ and width $w_L$. The contribution from magnetization transfer can be modelled by a Gaussian curve of Amplitude $A_G$ and width $w_G$. The fat signal can be modelled by a single- or multi-line MR spectrum of fat proton spins (of which the resonance frequencies are known a priori) of amplitude $A_F$. The parameters determined by fitting the modelled Z-spectrum background to the reconstructed (measured) Z-spectrum for each voxel are thus: amplitude $A_L$ and width $w_L$ of the Lorentzian curve modelling the direct water saturation, amplitude $A_G$ and width $w_G$ auf the Gaussian curve modelling the magnetization transfer, and amplitude $A_F$ of the multi-line spectrum modelling the fat signal. The fitting procedure is thus based on only five unknown parameters.

In yet a further embodiment, the number of different saturation frequency offsets, i.e. the number of points of the reconstructed Z-spectra is less than 50, preferably less than 20. It is an insight of the invention, that a limited number of Z-spectral points is sufficient to accurately determine the CEST contrast. The proposed acquisition with fat suppression in combination with the model of the Z-spectrum background leads to a stable fitting procedure even for a small number of acquired saturation frequency offsets. Stable fits can be obtained, e.g., with only 10-20 (preferably 15-18) acquired frequency offsets (with only five fitting parameters, see above). The fat suppression helps in this context because it leads to much smaller variations in the course of the Z-spectrum even with a high fat content in the respective voxel.

The method of the invention described thus far can be carried out by means of a MR system including at least one main magnet coil for generating a uniform steady magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstruction of a MR image from the received MR signals. The method of the invention is preferably implemented by a corresponding programming of the control unit and/or the reconstruction unit of the MR system.

The method of the invention can be advantageously carried out in most MR environments in clinical use at present. To this end it is merely necessary to utilize a computer program by which a computer (e.g. a PC) is controlled such that it performs the above-explained method steps of the invention. The computer program may be present either on a data carrier or be present in a data network so as to be downloaded for installation, e.g. into the control unit or the reconstruction unit of an MR system.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

    Fig. 1 shows an MR system according to the invention;
    Fig. 2 shows a flow chart illustrating the method of the invention;
    Fig. 3 shows a Z-spectrum reconstructed and fitted according to the invention;
    Fig. 4 shows a phantom setup for testing the method of the invention;
    Fig. 5 shows image results obtained by the method of the invention carried out on the phantom setup of Fig. 3;
    Fig. 6 shows a Z-spectrum reconstructed and fitted according to the invention, without fat suppression.

DETAILED DESCRIPTION OF EMBODIMENTS

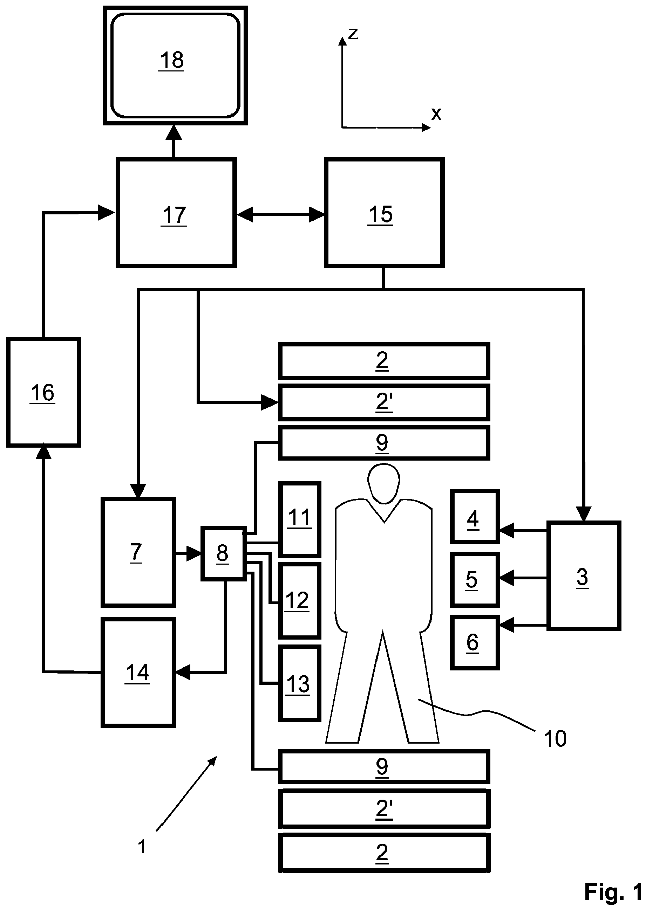

With reference to Fig. 1, an MR system 1 is shown. The device comprises superconducting or resistive main magnet coils 2 such that a substantially uniform, temporally constant main magnetic field Bo is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments which, together with any applied magnetic field gradients, achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the shimming coils 2' as well as the gradient pulse amplifier 3 and the transmitter 7 to generate any of a plurality of MR imaging protocols, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in the acquisition of raw image data.

Ultimately, the digital raw image data are reconstructed into an image representation by a reconstruction processor 17 which applies a Fourier transform or other appropriate reconstruction algorithms, such as SENSE or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

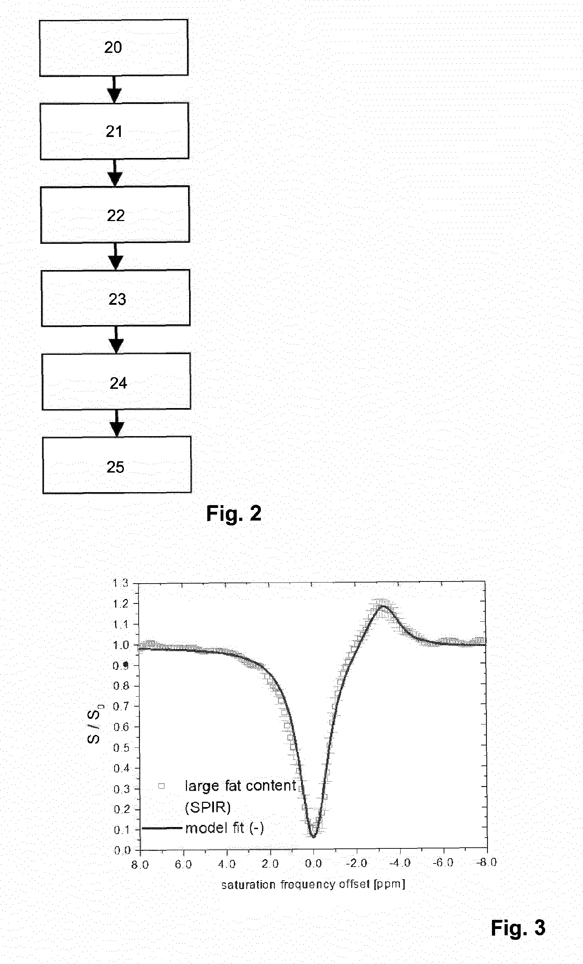

With reference to the flow chart shown in Fig. 2 and with further reference to Fig. 1, the sequence of method steps according to an embodiment of the invention is explained in the following.

In step 20, the portion of the body 10 is subjected to a CEST imaging protocol including saturation RF pulses at different saturation frequency offsets prior to acquisition of MR signals by means of, e.g., a spin echo sequence, which can be a fast spin echo (FSE) or turbo spin echo (TSE) sequence or a related pulse sequence like GRASE. The saturation RF pulses are irradiated via the body RF coil 9 and/or via the array RF coils 11, 12, 13, wherein the saturation frequency offset relative to the MR frequency of water protons is set by appropriate control of the transmitter 7 via the host computer 15. Different saturation frequency offsets are applied between, e.g., +/- 3.5 ppm around the MR frequency of water protons (at 0 ppm). A further reference acquisition may be performed "off-resonant", i.e. with a very large frequency offset, which leaves the MR signal amplitude of water protons unaffected, or with the RF saturation power switched off. The used CEST imaging protocol further includes fat suppression RF pulses, e.g. according to the known SPIR, SPAIR, or STIR schemes.

In step 21, a Z-spectrum is computed for each voxel of a given MR image slice or volume. This means that the quotient S/So of the MR signal amplitude S acquired at a given saturation frequency offset divided by the MR signal amplitude So of the reference acquisition is calculated for each voxel position and for each saturation frequency offset used in the acquisition step 20. Fig. 3 shows an example Z-spectrum for one selected voxel.

In step 22, a Bo map is obtained, e.g., via a Dixon technique, either using (parts of) the Z-spectral acquisition in step 20 (applying an appropriate variation of the echo time $T_E$) or a separate $B_0$ mapping scan.

In step 23, the computed Z-spectra are corrected for Bo inhomogeneity by applying a saturation frequency offset correction (i.e. a shift of the Z-spectrum in the direction of the saturation frequency axis in Fig. 3) according to the Bo map.

In step 24, a model $S_{model}(f)$ of the Z-spectrum background is fitted to the computed and Bo-corrected Z-spectra. Therein, direct water saturation is modelled by a Lorentzian curve of amplitude $A_L$ and width $w_L$, magnetization transfer is modelled by a Gaussian curve of Amplitude $A_G$ and width $w_G$, the fat signal is modelled by an inverted (due to fat suppression) multi-line MR spectrum of fat protons of amplitude AF. The model can thus be written as:

$$S_{model}(f) = S_0 - \left| A_L \frac{w_L^2}{f^2 + w_L^2} + A_G \frac{1}{\sqrt{2\pi} w_G} e^{-\frac{1}{2}\left(\frac{f}{w_G}\right)^2} - A_F \sum_{l=1}^{N_l} \frac{w_f^2}{(f-f_l)^2 + w_f^2} e^{-2\pi i f_l T_E} \right|$$

The five variable model parameters are sufficient: $A_L$, $A_G$, $A_F$, and $w_L$, $w_G$. All distributions are centered after Bo-correction. The frequencies and widths of the spectral lines of the fat protons ($f_l$, $w_f$) are known a priori. $T_E$ is the relevant echo time of the imaging sequence used for MR signal acquisition. This model is fitted to the Bo-corrected Z-spectrum for each voxel, wherein the data of the reconstructed and Bo-corrected Z-spectra in the spectral range affected by the CEST effect of interest (e.g. at 3.5 ± 1.5 ppm) is omitted in the fitting procedure in order to make sure that the resulting model corresponds to the background of the Z-spectrum only (without the asymmetry caused by the CEST effect).

Finally, in step 25, a CEST contrast image is derived by computing the difference between the modelled Z-spectrum background and the reconstructed Z-spectrum, within the region of the Z-spectrum affected by the CEST effect (e.g. at 3.5 ± 1.5 ppm) for each voxel.

The data points in Fig. 3 form a Z-spectrum (acquired from a phantom) of an image voxel with about 50% fat fraction using SPIR fat suppression during the MR signal acquisition. The spectral area around the main fat frequency at -3.4 ppm shows a signal elevation above the level without CEST saturation (So, normalized to 1.0). The model of the Z-spectrum background (solid curve), including direct water saturation, magnetization transfer effects, and the inverted fat spectrum largely approximates the measured background. The phantom shows no CEST signal at around 3.5 ppm. If present, the CEST contrast is derived as a difference between data points of the measured Z-spectrum and the curve of the model Z-spectrum at the respective frequency. Hence, no asymmetry analysis is performed, as is usual in conventional CEST approaches.

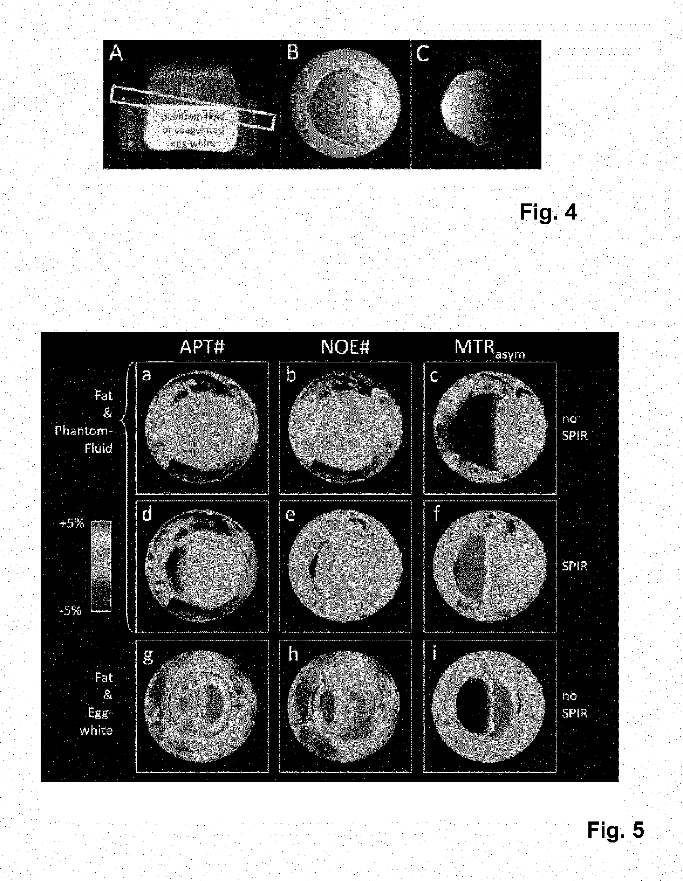

Phantom tests of the method of the invention were performed using a phantom at 3 Tesla with dual-channel RF transmission using a 16-channel head coil and 2$^{nd}$-order Bo shimming. Two phantoms were used with sunflower oil on top and (1) phantom fluid (water plus 0.8 g/l $CuSO_4$, Ti=450ms, no APT/CEST effect) or (2) egg-white (APT/CEST effect), coagulated (10 min at 60° C) to obtain magnetization transfer effects. An oblique MR image slice provided a range of partial volume fat effects. Fig. 4A shows the phantom setup in detail using sunflower oil for the fat component and (1) phantom fluid or (2) coagulated egg-white for the APT/CEST and magnetization transfer effects. The cross section of the oblique MR image slice is shown in Fig. 4A as a white box. There is correspondingly a large variation of voxel fat fraction across the slice. Fig. 4B illustrates the cross section through the phantom according to the oblique image slice. Fig. 4C shows a corresponding fat fraction MR image acquired using a GRE Dixon protocol.

During the test of the method of the invention, 40 RF pulses of 50 ms duration were alternatingly transmitted via the RF channels (100% duty cycle), resulting in a saturation time of $T_{sat} = 2$ s and an RF field strength of $B_{l,rms} = 2$ μT. A single-shot 2D fast-spin echo (FSE) sequence with and without SPIR fat suppression was used with a field of view of (160 mm)$^2$, the voxel size was $1.2 \times 1.2 \times 8$ mm$^3$, The repetition and echo times were $T_R/T_E = 5700$ ms /7.0 ms, with a flip angle of 90°, a refocusing angle of 120°, centric k-space ordering, and N = 17 saturation frequency offsets (±1560 (So), ±7.8, ±6.3, ±5.1, ±3.9, ±2.9, ±1.8, ±0.9, ±0.3 ppm). The total acquisition time was $T_{acq} = 2$ min.

A 3-point multi-acquisition GRE Dixon sequence with the same geometry was used for $B_0$ mapping: $T_R = 14$ ms, $T_E = 0.6$ ms, flip angle = 35°, 8 averages, $T_{acq} = 45$ s.

Z-spectra were computed and interpolated to 100 points including Bo correction as described above. Five parameters were fitted: $A_L$, $A_G$, $A_F$, $w_L$, $w_G$. Fixed fat proton linewidths $W_F$=110 Hz and fat frequencies fi ($N_1$=7 lines) were used, similar to common multi-peak Dixon water-fat separation. 11 interpolated points were selected for the fitting procedure, at ±7.0, ±4.5, -3.4, -2.3, ±1.3, -0.9, ±0.3 ppm, specifically excluding the range of amide (or amine) CEST effects (in the range from +1.3... +4.5 ppm). A CEST contrast image (APT#) was then derived as residuals from the Z-spectrum background fit. A further image (NOE#) was derived also as a residual from the fit at -3.5 ppm serving as a quality check for the fitting procedure. For comparison with the conventional approach, an asymmetry image (MTR$_{asym}$) was derived as (S(-3.5 ppm) - S(+3.5 ppm))/So from the measured Z-spectra (after $B_0$ correction).

Fig. 5 shows APT#, NOE#, and MTR$_{asym}$ images acquired from the phantom of Fig. 4 and resulting from the described model fitting. The images a-f are without and the images d-i are with APT/CEST and magnetization transfer effects from the partly coagulated egg-white. For images d-f, SPIR fat suppression was applied. A homogeneous, essentially zero intensity is observed in the APT# image a for the various fat contents across the image slice, while the MTR$_{asym}$ image c shows strong artifacts. As the APT# image d shows, some areas with high fat content cannot be adequately modeled. This is because of the low signal level. Signal overshoot leads to false hyperintensity in the $\text{MRT}_{asym}$ image f with SPIR. The APT# image g is hyperintense in egg-white containing areas (with strong CEST effect). The NOE# images b, e, h show overall low values, except for some dropouts/hyperintensity for SPIR in regions of high fat content (image e).

Further possible embodiments:
As the overall signal level maybe very small with fat suppression in areas of very high fat content (e.g., fat fraction >90 %), these areas can be masked, i.e. not included in the fitting process, as the fitting process may be unstable in these areas. Such areas do not provide information on the APT/CEST effect of interest, as these effects are only apparent on the water proton signal.

Optionally, Bo mapping/Bo correction steps may be skipped (steps 22, 23 in Fig. 2) and a further model parameter may be introduced instead, which takes the frequency center of the Z-spectrum into account. This may require more Z-spectral acquisitions. On the other hand, robustness could be increased against frequency shifts (e.g. due to patient motion) between separate Bo mapping and CEST acquisitions. The model fit would be able to identify Bo shifts in a large range of water/fat fractions.

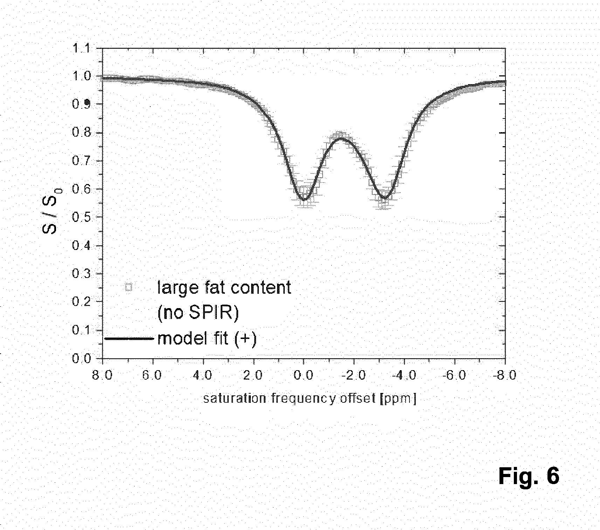

The above model $S_{model}(f)$ of the Z-spectrum background may be modified to fit Z-spectra without fat suppression. In this case, the fat content has a strong influence on the shape of the Z-spectrum. Fig. 6 shows a Z-spectrum acquired from the phantom for a voxel with about 50% fat fraction without fat suppression during acquisition. As compared to the acquisition with SPIR (Fig. 3), the spectrum is strongly altered by the fat content and can be complex depending on the applied echo time $T_E$. Nevertheless, the background of the Z-spectrum is successfully fitted with the model $S_{model}(f)$ according to the above equation, using a plus sign before $A_F$ for the fat spectrum. A stable fit cannot be ensured for all echo times $T_E$ though, (e.g. if the signal contributions from water and fat are out of phase).

## Claims

1. A method of MR imaging of at least a portion of a body (10) placed in a main magnetic field Bo within the examination volume of an MR system (1), the method comprising the following steps:

   a) acquiring MR signals by subjecting the portion of the body (10) to a CEST imaging protocol including RF saturation at a number of different saturation frequency offsets;
   b) reconstructing a Z-spectrum from the acquired MR signals for each voxel of an MR image;
   c) modelling a Z-spectrum background including contributions from direct water saturation, magnetization transfer, and fat signal, wherein parameters of the model are determined by fitting the modelled Z-spectrum background to the reconstructed Z-spectrum for each voxel, omitting a region of the Z-spectrum affected by the CEST effect; and
   d) deriving a CEST contrast image by computing the difference between the modelled Z-spectrum background and the reconstructed Z-spectrum for each voxel.

2. Method of claim 1, wherein the CEST imaging protocol further includes fat suppression.

3. Method of claim 1 or 2, further comprising the steps of:

   - obtaining a Bo map; and
   - applying a saturation frequency offset correction to the reconstructed Z-spectra according to the Bo map.

4. Method of any one of claims 1-3, wherein the Bo map is obtained from the acquired MR signals by means of a single-point or multi-point Dixon technique.

5. Method of any one of claims 1-4, wherein the number of different saturation frequency offsets, i.e. the number of points of the reconstructed Z-spectra is less than 50, preferably less than 20.

6. Method of any one of claims 1-5, wherein the contribution from direct water saturation is modelled by a Lorentzian curve of amplitude $A_L$ and width $w_L$.

7. Method of any one of claims 1-6, wherein the contribution from magnetization transfer is modelled by a Gaussian curve of Amplitude $A_G$ and width $w_G$.

8. Method of any one of claims 1-7, wherein the fat signal is modelled by a single- or multi-line MR spectrum of fat protons of amplitude $A_F$.

9. Method of claims 6-8, wherein the parameters determined by fitting the modelled Z-spectrum background to the reconstructed Z-spectrum for each voxel are: amplitude and width of the Lorentzian curve modelling the direct water saturation, amplitude and width auf the Gaussian curve modelling the magnetization transfer, amplitude of the multi-line spectrum modelling the fat signal.

10. MR system comprising:

- at least one main magnet coil (2) for generating a uniform, steady magnetic field within an examination volume;
- a number of gradient coils (4, 5, 6) for generating switched magnetic field gradients in different spatial directions within the examination volume;
- at least one RF coil (9) for generating RF pulses within the examination volume and/or for receiving MR signals from a body (10) of a patient positioned in the examination volume;
- a control unit (15) for controlling the temporal succession of RF pulses and switched magnetic field gradients; and
- a reconstruction unit (17) for reconstructing a MR image from the received MR signals,

wherein the MR device (1) is configured to perform the following steps:

a) acquiring MR signals by subjecting the portion of the body (10) to a CEST imaging protocol including fat suppression and RF saturation at a number of different saturation frequency offsets;
b) reconstructing a Z-spectrum from the acquired MR signals for each voxel of an MR image;
c) modelling a Z-spectrum background including contributions from direct water saturation, magnetization transfer, and fat signal, wherein parameters of the model are determined by fitting the modelled Z-spectrum background to the reconstructed Z-spectrum for each voxel, omitting a region of the Z-spectrum affected by the CEST effect; and
d) deriving a CEST contrast image by computing the difference between the modelled Z-spectrum background and the reconstructed Z-spectrum in the region of the Z-spectrum affected by the CEST effect for each voxel.

11. Computer program comprising instructions to be executed by a computer, wherein execution of the instructions causes the computer to perform the following steps:

a) receiving MR signals associated with a number of different saturation frequency offsets of a CEST imaging protocol;
b) reconstructing a Z-spectrum from the MR signals for each voxel of an MR image;
c) modelling a Z-spectrum background including contributions from direct water saturation, magnetization transfer, and fat signal, wherein parameters of the model are determined by fitting the modelled Z-spectrum background to the reconstructed Z-spectrum for each voxel, omitting a region of the Z-spectrum affected by the CEST effect; and
d) deriving a CEST contrast image by computing the difference between the modelled Z-spectrum background and the reconstructed Z-spectrum in the region of the Z-spectrum affected by the CEST effect for each voxel.

**Fig. 1**

**Fig. 2**

**Fig. 3**

**Fig. 4**

**Fig. 5**

**Fig. 6**

Europäisches
Patentamt

European
Patent Office

Office européen
des brevets

# EUROPEAN SEARCH REPORT

Application Number

**EP 23 17 2477**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHICHAO WANG ET AL: "A new approach for in-vivo liver CEST imaging", PROCEEDINGS OF THE JOINT ANNUAL MEETING ISMRM-ESMRMB 2022 & ISMRT ANNUAL MEETING, LONDON, UK, 07-12 MAY 2022, ISMRM, 2030 ADDISON STREET, 7TH FLOOR, BERKELEY, CA 94704 USA, no. 3846, 22 April 2022 (2022-04-22), XP040730394, * the whole document * * figures 1a-1f * | 1-11 | INV. G01R33/56 G01R33/48 G01R33/565 |
| A | MORITZ ZAI ET AL: "Quantitative separation of CEST effect from magnetization transfer and spillover effects by Lorentzian-line-fit analysis of z-spectra", JOURNAL OF MAGNETIC RESONANCE, vol. 211, no. 2, 15 May 2011 (2011-05-15), pages 149-155, XP028242342, ISSN: 1090-7807, DOI: 10.1016/J.JMR.2011.05.001 [retrieved on 2011-05-15] * Chapters 1. Introduction, 2. Theory and 3. Materials and Methods; figure 1 * * page 154, left-hand column, paragraph 2-4 * | 1-11 | |
| A | US 2021/063519 A1 (KEUPP JOCHEN [NL]) 4 March 2021 (2021-03-04) * paragraph [0060]; figure 4 * | 1-11 | TECHNICAL FIELDS SEARCHED (IPC) G01R |

The present search report has been drawn up for all claims

| Place of search | Date of completion of the search | Examiner |
|---|---|---|
| Munich | 11 October 2023 | Faber-Jurk, Sonja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 17 2477**

This annex lists the patent family members relating to the patent documents cited in the above-mentioned European search report.
The members are as contained in the European Patent Office EDP file on
The European Patent Office is in no way liable for these particulars which are merely given for the purpose of information.

**11-10-2023**

| Patent document cited in search report | | Publication date | Patent family member(s) | | Publication date |
|---|---|---|---|---|---|
| US 2021063519 | A1 | 04-03-2021 | CN | 111566497 A | 21-08-2020 |
| | | | EP | 3511729 A1 | 17-07-2019 |
| | | | EP | 3737957 A1 | 18-11-2020 |
| | | | JP | 2021510567 A | 30-04-2021 |
| | | | US | 2021063519 A1 | 04-03-2021 |
| | | | WO | 2019137837 A1 | 18-07-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6962769 B1

**Non-patent literature cited in the description**

- **ZHOU et al.** *Magnetic Resonance in Medicine,* 2008, vol. 60, 842-849